# EUROPEAN PATENT APPLICATION

(11) **EP 4 749 974 A1**
(43) Date of publication of application: **27.05.2026**
(21) Application number: 24215097.7
(22) Date of filing: 25.11.2024
(51) Int. Cl.: H04L 7/10

(54) **METASTABILITY DETECTOR AND CALIBRATION METHOD FOR SYNCHRONOUS DATA TRANSFER**

(71) Applicant: Stichting IMEC Nederland, 5656 AE Eindhoven (NL)
(72) Inventor: GAMAGE, Sahan, Cambridge, CB1 8NJ (GB); TRAFFERO, Stefano, 5655 BV Eindhoven (NL); TIURIN, Evgenii, 5667 BK Geldrop (NL)
(74) Representative: Sarlet, Stephanie

(57) **Abstract**

The present disclosure provides a metastability detector (60) and a calibration method for ensuring synchronous data transfer in distributed synchronous systems (10). By providing a metastability detector (60) that integrates hardware adapted to, for reference signal patterns sent from first transceiver device to a second transceiver device, determine a metastability value based on deviations from the 50% duty cycle, and by providing a calibration method that adjust clock phases of generated signal patterns based on metastability values determined by measuring deviations from the 50% duty cycle, embodiments of the present disclosure can ensure reliable, high-speed data transfer with minimal synchronization issues in distributed synchronous systems (10). The approach may further account for variations over time and because of operating conditions, thereby maintaining optimal performance of data transfer in distributed synchronous systems (10).

## Description

### Technical field of the disclosure

The present disclosure relates to the field of high-speed data communication in distributed digital hardware systems, and more specifically to methods and devices for reliable synchronous data transfer.

### Background art

High-speed data transfer between distributed digital hardware systems is integral to the performance of various modern technologies, such as, for example, ultra-wideband (UWB) transceivers, radar systems, or localization networks. These systems often rely on synchronous communication, where the transmitter (TX) and receiver (RX) operate on aligned frequencies to ensure accurate data exchange. However, achieving reliable phase synchronization between distributed components presents significant challenges.

One concern in high-speed synchronous data transmission is the distortion or degradation of reference clock signals transmitted between the RX and TX systems. The frequency at which the clock signals start to degrade or start being distorted may depend on a lot of factors, such as, for example, the process node/technology used to manufacture the circuit, or packaging, and can also depend on operational conditions such as temperature of operation and/or supply voltage.

Even with the use of techniques like Low Voltage Differential Signaling (LVDS), clock signals can become distorted or degraded due to factors such as signal attenuation and electromagnetic interference. This degradation can make it difficult for the TX system to accurately reproduce the RX clock for its digital operations.

Additionally, the physical signal path between the TX and RX may introduce further complications. Signals go through a series of components, such as for example, connectors, bonding wires and the like, each contributing to potential signal delay and distortion. This can alter the clock phase by the time the signal reaches the RX digital sampling point, leading to inconsistencies in data timing.

In applications requiring precise timing synchronization these timing uncertainties can have negative effects. Variations in delay can introduce unacceptable levels of jitter, undermining the accuracy and reliability of the distributed system.

Despite existing methods to address some of these issues, such as improving connection quality or reducing operational frequencies, challenges remain in ensuring reliable high-speed data transfer without compromising performance in distributed synchronous systems. Environmental factors like temperature fluctuations and variations in connector wiring may further increase the chance of metastability occurring.

### Summary of the disclosure

It is an aim of the present disclosure to provide a metastability detector for detecting metastability of a received signal in a distributed synchronous system.

It is a second aim of the present disclosure to provide a method for calibrating a distributed synchronous system.

It is a third aim of the present disclosure to provide a distributed synchronous system comprising at least a metastability detector according to embodiments of the present disclosure.

It is a fourth aim of the present disclosure to provide a method for enabling reliable high-speed data transfer in a distributed synchronous system using a metastability detector according to embodiments of the present disclosure.

In a first aspect, which may be combined with other aspects and/or embodiments described herein, the present disclosure relates to a metastability detector for detecting metastability of a received signal in a distributed synchronous system, the metastability originating from clock phase misalignment resulting from sending the signal from a first transceiver device, e.g. a transmitter device, to a second transceiver device, e.g. a receiver device, of the distributed synchronous system. The metastability detector comprises an input configured to receive a re-synchronized signal pattern from a synchronizer device of the second transceiver device, e.g. receiver device, the re-synchronized signal pattern being obtained by re-synchronization to a signal pattern present in the received signal and resulting from a toggle sequence generated in the first transceiver device, e.g. the transmitter device, with a first clock phase and a 50% duty cycle. The metastability detector further comprises an interval counter configured to increment when the re-synchronized signal pattern is equal to 1 and to decrement when the re-synchronized signal pattern is equal to 0 or vice versa for subsequent logic level intervals of the re-synchronized signal pattern and control logic configured to accumulate an absolute value of the interval counter at the end of each logic level interval and to provide a metastability value based on the accumulated absolute value. A metastability detector according to embodiments of the present disclosure can be used in any highspeed data system such as, for example but not limited to, Ultra Wide Band (UWB) systems, localisation detector setup systems, radar systems, monitoring systems etc., where synchronous clocks are important. An advantage of a metastability detector according to embodiments of the present disclosure is that it does not require any pre-defined pattern, but only requires the first transceiver device logic 0 and logic 1 durations to be the same. Since it only reports metastability at logic edges, e.g. logic 0 to logic 1 transition, simply keeping the input at, for example, logic 0 at the beginning or end of the toggle sequence is adequate as pattern termination, making software control of this detector simple.

According to embodiments of the present disclosure, the metastability detector may further comprise an internal register for saving the metastability value. The internal register may be accessible to external software.

The control logic may further be configured to compare the accumulated counts to a predetermined threshold to determine if a metastability event has occurred. In that way, metastability can be determined in an accurate manner.

In a second aspect, which may be combined with other aspects and/or embodiments described herein, the present disclosure relates to a method for calibrating a distributed synchronous system comprising a first transceiver device with a first transceiver digital sub-system connected to a second transceiver device with a second transceiver digital sub-system via an external connection. The method comprises:
a. generating a toggle sequence with a clock phase and a 50% duty cycle in a pattern generator in the first transceiver digital sub-system, and transmitting a signal containing the toggle sequence to the second transceiver,
b. receiving the signal in the second transceiver, and synchronizing to a signal pattern present in the received signal and resulting from the toggle sequence by means of a synchronizer device in the second transceiver digital sub-system, thereby obtaining a re-synchronized signal pattern,
c. incrementing an interval counter when the re-synchronized signal pattern is equal to 1 and decrementing the interval counter when the re-synchronized signal pattern is equal 0 or vice versa for subsequent logic level intervals of the re-synchronized signal,
d. accumulating an absolute value of the interval counter at the end of each logic level interval and providing a metastability value based on the accumulated absolute value,
e. optionally, repeating steps a to d at least once for a further toggle sequence with a different clock phase and with a 50% duty cycle, thereby obtaining at least one further metastability value and
f. evaluating whether the obtained metastability value or values reflect a minimal or zero metastability,
g. determine a reference clock phase correlated with the respective metastability value reflecting the minimal or zero metastability, and
h. adjust the clock phase of a signal for data transfer from the first transceiver device to the second transceiver device or vice versa according to the reference clock phase.

The evaluation step may, according to embodiments of the present disclosure, comprise comparing the obtained metastability value or values with a predetermined value. In that way, the metastability values can be determined in an accurate way. According to specific embodiments, steps a to d may be repeated for subsequent toggle sequences of which the clock phase is adjusted in discrete steps over a range of clock phases.

To be sure that metastability is as low as possible, according to embodiments of the present disclosure, the method may further comprise periodically re-run steps a to h in between data transfer operations.

In a third aspect, which may be combined with other aspects and/or embodiments described herein, the present disclosure relates to a distributed synchronous system comprising a first transceiver device with a first transceiver digital sub-system connected to a second transceiver device with a second transceiver digital sub-system via an external connection. The first transceiver digital sub-system comprises a pattern generator for generating a toggle sequence with a clock phase and a 50% duty cycle and is configured to generate subsequent toggle sequences with different clock phases. The second transceiver digital sub-system comprises a synchronizer device, which may, for example, comprise at least two Flip-Flop synchronizers, configured to receive a signal pattern present in a received signal and resulting from a toggle sequence generated in the first transceiver device, and to produce a re-synchronized signal pattern by re-synchronization to the received signal pattern, and a metastability detector device to provide a metastability value of the re-synchronized signal pattern indicative of the degree of metastability of the re-synchronized signal pattern. The metastability detector device comprises at least one metastability detector according to embodiments of the present disclosure, and/or the distributed synchronous system is configured to perform, before use or in between data transfer operations, a calibration method according to embodiments of the present disclosure for obtaining synchronized data transfer between the first transceiver device and the second transceiver device. An advantage of a distributed synchronous system according to embodiments of the present disclosure is that reliable high-speed data transfer between a first transceiver device and a second transceiver device can be achieved even when clock phase synchronicity cannot be guaranteed due to environmental and/or operational factors. Metastability events in signals received in the second transceiver device can be reduced or eliminated, thereby increasing data transfer reliability.

According to embodiments of the present disclosure, the metastability detector system may further comprise at least one XOR based metastability detector and/or at least one pattern based metastability detector.

The system may be configured to periodically re-run the calibration sequence in between data transfer operations.

According to embodiments of the present disclosure, the first transceiver device may, for example, comprise a field-programmable gate array with a phase-locked loop for clock phase adjustment.

According to embodiments of the present disclosure, the second transceiver device may, for example, comprise an integrated circuit configured to provide a reference clock phase to the first transceiver device.

The external connection may comprise a transmitter core, transmitter pads, wires, receiver pads and a receiver core.

In a fourth aspect, which may be combined with other aspects and/or embodiments described herein, the present disclosure relates to a method for enabling reliable high-speed data transfer in a distributed synchronous system comprising a first transceiver device with a first transceiver digital sub-system connected to a second transceiver device with a second transceiver digital sub-system via an external connection. The method comprises in a first step implementing, at the second transceiver digital sub-system, a metastability detector device configured to detect metastability events resulting from clock phase misalignment, the metastability detector system comprising at least one metastability detector according to embodiments of the present disclosure. In a second step, the method comprises providing at the first transceiver device, a pattern generator for generating a toggle sequence with a particular clock phase and a 50% duty cycle, and configured to adjust the clock phase over a range of phases and to generate subsequent toggle sequences corresponding to each adjusted clock phase, and/or performing, before use and/or in between data transfer operations, a calibration method according to embodiments of the present disclosure. Then, the method comprises selecting a clock phase resulting in a minimal or zero metastability for data transfer and transferring data from the transmitter device to the receiver device using the selected clock phase.

### Brief description of the drawings

Embodiments of the present disclosure will be discussed in more detail below, with reference to the attached drawings.
Fig. 1 schematically illustrates a distributed synchronous system according to embodiments of the present disclosure.
Fig. 2 schematically illustrates a diagram of an example of a metastability detector according to embodiments of the present disclosure.
Fig. 3 is a timing diagram showing possibilities of metastable edges and the result of a metastability detector according to embodiments of the present disclosure.

### Description of illustrative embodiments

Below, particular embodiments according to the disclosure are described with reference to certain drawings but the disclosure is not limited thereto. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

The terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

The terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The present disclosure will hereinafter be described by means of different embodiments. It has to be understood that these embodiments are only for the ease of understanding the present disclosure and are not intended to limit the disclosure in any way.

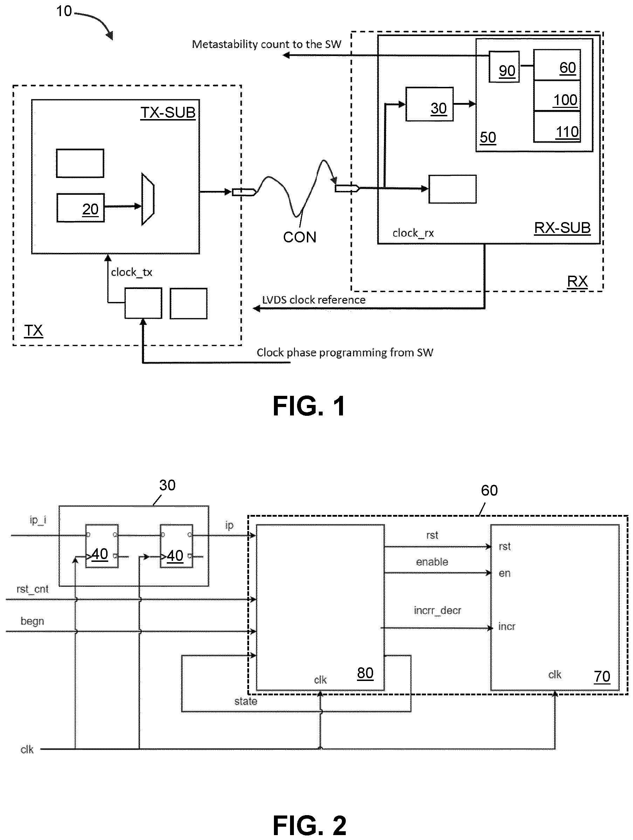

Fig. 1 schematically illustrates a distributed synchronous system 10 according to embodiments of the present disclosure. A "distributed synchronous system", as used herein and unless otherwise specified, refers to a network of interconnected devices or components that operate with synchronized clock signals, thereby allowing data exchange across the different devices within the system. Examples of such distributed synchronous systems may be but are not limited to any highspeed data system such as for example, Ultra-Wide Band (UWB) systems, localisation detector setup systems, radar systems, monitoring systems, multi-module computing systems, synchronized communication networks, clock-synchronized industrial control systems, ..., where synchronous clocks are important.

The distributed synchronous system 10 comprises a first transceiver device, e.g. transmitter device TX, and a second transceiver device, e.g. receiver device RX.

The term "first transceiver device" refers to a transmitting component in the distributed synchronous system that both sends and receives signals but is primarily responsible for generating and transmitting a toggle sequence to the second transceiver device. Specific examples may comprise a transmitter device, such as a field-programmable gate array (FPGA) configured for signal transmission.

The term "second transceiver device" refers to a receiving component in the distributed synchronous system that both sends and receives signals but is primarily responsible for receiving signals from the first transceiver device and processing them through synchronization and metastability detection mechanisms. Examples may include a receiver device, such as, for example, an integrated circuit (IC) configured to handle incoming data signals.

According to embodiments of the present disclosure, the first transceiver device may, for example, be a field-programmable gate array (FPGA) with a phase-locked loop (PLL) for flexible clock phase adjustment and the second transceiver device may, for example, be an integrated circuit providing a reference clock phase to the first transceiver device, ensuring stable synchronization.

The present disclosure will be further described by means of a transmitter device TX as a first transceiver device and a receiver device RX as a second transceiver device, but this is not intended to limit the present disclosure in any way, this is only for the ease of explanation. The transmitter device TX may be connected to the receiver device RX via an external connection CON, which may comprise a transmitter core, transmitter pads, wires, receiver pads and a receiver core.

The transmitter device TX comprises a transmitter digital sub-system TX-SUB which comprises a pattern generator 20 capable of generating toggle sequences with a particular clock phase and a 50% duty cycle. "50% duty cycle" refers to a signal characteristic where the signal is in the high state ('1') for half of the period and in the low state ('0') for the other half, resulting in equal durations of logic'1' and logic'0' states within each cycle. The pattern generator 20 may be configured to generate subsequent toggle sequences, each toggle sequence having a different clock phase which may be part of a range of clock phases. The clock phase of the generated patterns can be adjusted and programmed by external software (see further).

As used herein and unless otherwise specified, the term "toggle sequence" refers to a predetermined pattern of alternating logical states (logic1 and logic0) generated by the transmitter device TX with a specific clock phase and duty cycle, according to the present disclosure a 50% duty cycle, and used herein to calibrate the synchronization between the transmitter device TX and the receiver device RX.

When a signal is transmitted from the transmitter device TX to the receiver device RX in a distributed synchronous system, metastability may arise due to clock phase misalignment. With "metastability" is meant a condition in digital circuits where a signal fails to settle into a stable logical state within an expected time frame, often due to asynchronous inputs or timing violations, leading to unpredictable behaviour. Metastability may refer to a situation where the system's behaviour becomes unpredictable and unstable due to asynchronous interaction between the transmitter device TX and the receiver device RX. "Clock phase misalignment" may refer to the discrepancy in timing between the clock signals of the transmitter device TX and the receiver device RX.

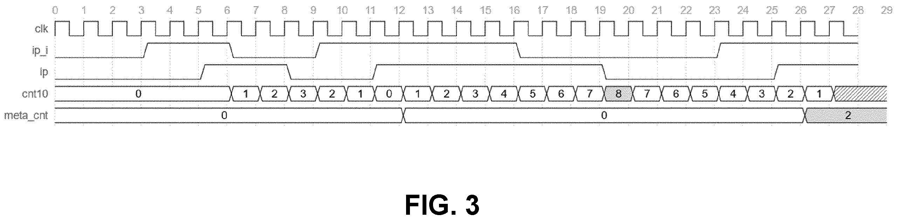

Therefore, the receiver device RX comprises, in a receiver digital sub-system RX-SUB, a synchronizer device 30 adapted for receiving a signal comprising the generated signal pattern (ip_i in Figs. 2 and 3), resulting from the toggle sequence generated in the transmitter device TX. From this received signal ip_i, the synchronizer device 30 produces a re-synchronized signal pattern (ip in Figs. 2 and 3) by re-synchronization of the received signal pattern. The re-synchronized signal pattern ip is thus the signal obtained after the signal that was received from the transmitter device TX has been processed by the synchronizer device 30, thereby aligning that received signal ip_i with the clock of the receiver device RX.

The synchronizer device 30 may comprise two or three back to back digital Flip Flop synchronizers 40 (see Fig. 2). Having multiple Flip Flop synchronizers 40 may be to reduce the probability of metastability in the re-synchronized signal. Using two or three Flip Flop synchronizer 40 will already reduce metastability in the re-synchronized signal to a great extent. However, the back to back digital Flip Flop synchronizers 40 will incur different clock delays due to preceding Flip Flop synchronizer in the chain missing the voltage transition when metastability happens. In other words, this may introduce an unpredictable delay in the captured output vs input of the synchronizer device 30. Therefore, the receiver digital sub-system RX-SUB further comprises a metastability detector device 50 to provide a metastability value of the re-synchronized signal pattern indicative of the degree of metastability of the re-synchronized signal pattern. The metastability detector device 50 may comprise at least one metastability detector 60 according to embodiments of the present disclosure. The metastability detector 60 comprises an input configured to receive the re-synchronized signal pattern from the synchronizer device 30. This re-synchronized signal pattern is obtained by resynchronizing to a signal pattern present in the received signal, which results from a toggle sequence generated in the transmitter device TX with a specific clock phase and a 50% duty cycle.

As illustrated in Figure 2, the metastability detector 60 comprises an interval counter 70 and control logic 80. The interval counter 70 is configured to increment when the re-synchronized signal pattern equals 1 and to decrement when it equals 0, or vice versa, for subsequent logic level intervals of the re-synchronized signal pattern (signal incrr_decr in Fig. 2). The control logic 80 is configured to accumulate an absolute value of the interval counter 70 at the end of each logic level interval and to provide a metastability value based on the accumulated absolute value.

According to embodiments of the present disclosure, the control logic 80 may further be configured to compare the accumulated counts to a predetermined threshold to determine if a metastability event has occurred, providing a clear indication of problematic metastability.

Additionally, the metastability detector 60 may comprise an internal register 90 for saving the metastability value. The internal register 90 may be accessible to external software, facilitating easy monitoring and analysis of metastability events. Further, clock phase programming of the signal pattern in the pattern generator 20 can then be done using the metastability values saved in the internal register 90.

A metastability detector 60 according to embodiments of the present disclosure may also be referred to as an interval-based detector.

According to embodiments of the present disclosure, the metastability detector device 50 may furthermore comprise, next to the at least one metastability detector 60 according to embodiments of the present disclosure, at least one pattern-based detector 100. A pattern based detector 100 is based on a deterministic calibration pattern sent by the transmitter device TX. Logic1 and Logic0 level durations for the used pattern should be pre-programmed in the pattern-based detector 100. When active, the pattern-based detector 100 tries to synchronize itself with a pattern using first Logic 0 to Logic 1 transition at the input. The transmitter device TX starts reference pattern generation based on pre-programmed pattern parameters). The receiver device RX counts the mismatches of reference-vs-incoming pattern. This then forms the metastability counter of the pattern-based detector 100. The pattern-based detector 100 can be an additional detector 100 to be used next to an interval-based detector 60 according to embodiments of the present disclosure. Using such pattern-based detector 100 in combination with an interval-based metastability detector 60 according to embodiments of the present disclosure, may alter the working of a metastability detector device 50 compared to when only a pattern-based detector 100 would be used.

A disadvantage of such pattern-based detector 100 may be that the pattern that is generated by it has to be pre-agreed between the transmitter device TX and the receiver device RX. Hence, all the possible various patterns have to be anticipated at the time of implementation.

In still further embodiments of the present disclosure, the metastability detector device 50 may further comprise at least one XOR-based detector 110. A XOR-based detector 110 is working based on a metastability detection scheme that is supposed to capture a metastability condition, i.e. slow transition between first and second re-synchronizer Flip Flop synchronizer, by sampling the signal after the first Flip Flop synchronizer flow at a different time and then comparing the resulting logic levels. Mismatch events are then counted a metastability counter of the XOR-based detector 110. A XOR-based detector 110 can, similar as for the pattern-based detector 100, be used next to an interval-based detector 60 according to embodiments of the present disclosure. Using such XOR-based detector 110 in combination with an interval-based metastability detector 60 according to embodiments of the present disclosure, may alter the working of a metastability detector device 50 compared to when only a XOR-based detector 110 would be used. A XOR-based detector 110 may, for some applications, have a propagation delay, which means there is a time lag between when the metastability occurs and when it is detected. This delay can especially be significant in high-speed systems.

According to preferred embodiments and as illustrated in Fig. 1, a distributed synchronous system 10 according to embodiments of the present disclosure may comprise at least one metastability detector 50 according to embodiments of the present disclosure in combination with at least one pattern-based detector 100 and at least one XOR-based detector 110.

The distributed synchronous system 10 may further be configured to perform, before use or in between data transfer operations, a calibration method according to embodiments of the present disclosure for obtaining synchronized data transfer between the transmitter device TX and the receiver device RX.

Hence, in a further aspect, the present disclosure provides a method for calibrating a distributed synchronous system 10 comprising a first transceiver device, e.g. a transmitter device TX, with a first transceiver digital sub-system, e.g. a transmitter digital sub-system TX-SUB, connected to a second transceiver device, e.g. receiver device RX, with a second transceiver digital sub-system, e.g. a receiver digital sub-system RX-SUB, via an external connection CON. Again, similar as for the description of the distribute synchronous system 10, a transmitter device TX and a receiver device RX will be used to describe the calibration method according to embodiments of the present disclosure. However, this is only for the ease of explanation and is not intended to limit the present disclosure in any way.

The method comprises:
a. generating a toggle sequence with a particular clock phase and a 50% duty cycle in a pattern generator (20) in the transmitter digital sub-system TX-SUB, and transmitting a signal ip_i containing the toggle sequence to the receiver device RX,
b. receiving the signal ip_i in the receiver device RX, and synchronizing to a signal pattern present in the received signal ip_i and resulting from the toggle sequence by means of a synchronizer device 30 in the receiver digital sub-system RX-SUB, thereby obtaining a re-synchronized signal pattern ip,
c. incrementing an interval counter 70 when the re-synchronized signal pattern is equal to 1 and decrementing the interval counter 70 when the re-synchronized signal pattern is equal 0 or vice versa (signal incrr_decr in Fig. 2) for subsequent logic level intervals of the re-synchronized signal ip,
d. accumulating an absolute value of the interval counter 70 at the end of each logic level interval and providing a metastability value based on the accumulated absolute value,
e. optionally, repeating steps a to d at least once for a further toggle sequence with a different clock phase and with a 50% duty cycle, thereby obtaining at least one further metastability value,
f. evaluating whether the obtained metastability value or values reflect a minimal or zero metastability,
g. determine a reference clock phase correlated with the respective metastability value reflecting the minimal or zero metastability, and
h. adjust the clock phase of a signal for data transfer from the first transceiver device to the second transceiver device or vice versa according to the reference clock phase.

According to embodiments of the present disclosure, steps a to d may be repeated for subsequent toggle sequences of which the clock phase is adjusted in discrete steps over a range of clock phases.

According to embodiments of the present disclosure, the calibration method may comprise generating toggle sequences at varying clock phases stepped over a full 360-degree range from the transmitter device TX to the receiver device RX. Metastability values may be measured at the receiver device RX for each clock phase. The method may identify the clock phase corresponding to the highest measured metastability value and then select a clock phase for subsequent data transfer that is approximately 180 degrees offset from this phase to minimize metastability during operation. By selecting a clock phase offset by approximately 180 degrees from the clock phase at which maximum metastability is observed, the system may operate, and thus data transfer between the transmitter device TX and receiver device RX may occur, at the phase with minimal metastability risk.

Evaluating the metastability values may comprise comparing these values with a predetermined threshold to ascertain if metastability is within acceptable limits. Repeating the toggle sequence generation and metastability determination steps over a range of clock phases may enable finding the optimal clock phase that minimizes metastability. Periodically re-running the calibration steps between data transfer operations may then account for any changes in operating conditions over time and may be done to be sure that data transfer between the transmitter device TX and the receiver device RX is always done in a best way, i.e. with at least a reduced amount of metastability in the signal received in the receiver device RX. In preferred cases, data transfer may occur without any form of metastability in a signal after being sent from the transmitter device TX to the receiver device RX.

The distributed synchronous system 10 may further be designed to periodically re-run the calibration sequence in between data transfer operations, ensuring optimal synchronization over time. Hence, "normal" data transfer operations may be, at certain times, alternated with calibration sequences. This ensures data transfer with substantially no metastability after the signal is sent from the transmitter device TX to the receiver device RX, or at least with a reduced metastability.

In still a further aspect, the present disclosure provides a method for enabling reliable high-speed data transfer in a distributed synchronous system 10 comprising a first transceiver device, e.g. transmitter device TX, with a first transceiver digital sub-system, e.g. a transmitter digital sub-system TX-SUB, connected to a second transceiver device, e.g. receiver device RX, with a second transceiver digital sub-system, e.g. receiver digital sub-system RX-SUB, via an external connection CON. The method comprises in a first step implementing, at the second transceiver digital sub-system, a metastability detector device 50 configured to detect metastability events resulting from clock phase misalignment. The metastability detector device 50 comprises at least one metastability detector embodiments of the present disclosure. In a second step, the method comprises providing at the first transceiver device TX, a pattern generator (20) for generating a toggle sequence with a particular clock phase and a 50% duty cycle and configured to generate toggle sequences with different clock phases, and/or performing, before use and/or in between data transfer operations, a calibration method according to embodiments of the present disclosure. The method then further comprises selecting a clock phase resulting in a minimal or zero metastability for data transfer and transferring data from the transmitter device (TX) to the receiver device (RX) using the selected clock phase.

According to embodiments of the present disclosure, the metastability detector device 50 may further comprise at least one pattern-based detector 100 and/or at least one XOR based detector 110, next to the at least one interval-based metastability detector 60 according to embodiments of the present disclosure.

Fig. 3 shows a diagram illustrating possible metastable edges and the operation of the interval-based metastability detector 60 according to embodiments of the present disclosure. In the example given in Fig. 3, the toggle sequence ip_i generated by pattern generator 20 in the transmitter digital sub-system TX-SUB is sent to the receiver device RX as part of the calibration process according to embodiments of the present disclosure. In the example given it is assumed that the edge at clock 16 of ip_i has become metastable. Because of that, the synchronizer device output (ip) will be one cycle delayed to clock number 19. All the other edges remain the same as would be without metastability. This means that only at clock number 19 ip has a different delay compared to ip_i, all the other edges in ip are 2 clocks delayed with respect to ip_i, whereas ip_i at clock 16 is delayed by three clocks due to metastability only affecting that edge. Because, relatively, this makes logic 1 one cycle longer and logic 0 one less, it will count 2 as the metastability counter value. The meta_cnt is then saved in the internal register 90 and can be read back by external software that runs the calibration routine.

In practice, the interval counter 70 checks the durations of Logic 0 and Logic 1 intervals. It increments when the re-synchronized pattern value equals 1 and decrements when it equals 0, or vice versa. Ideally, without edge jitter or metastability, the interval counter 70 resets to zero at the end of each Logic 0/Logic 1 cycle due to the 50% duty cycle (signal rst in Fig. 2). However, any non-zero value indicates unequal intervals caused by edge jitter or metastability. The absolute value of the interval counter 70 at the end of each cycle is added to the metastability count. The interval counter 70 is then reset for the next set of Logic 1/0 intervals.

Compared to prior art techniques like, for example, the XOR-based metastability detector, which detects metastability by comparing signals sampled at different clock edges, the interval-based metastability detector 60 according to embodiments of the present disclosure provides a more nuanced detection by focusing on interval durations and leveraging the expected 50% duty cycle of the calibration pattern. This is also why the metastability detector according to embodiments of the present disclosure is referred to as interval-based detector 60.

The present disclosure thus offers an efficient solution for detecting and mitigating metastability of signals in distributed synchronous systems 10. By providing a metastability detector 60 integrating hardware such as an interval counter 70 and control logic 80 adapted to determine a metastability value based on deviations from the 50% duty cycle, and by providing a calibration method that adjust clock phases based on metastability values determined by measuring deviations from the 50% duty cycle, embodiments of the present disclosure can ensures reliable, high-speed data transfer with minimal synchronization issues in distributed synchronous systems 10. The approach may further account for variations over time and because of operating conditions, thereby maintaining optimal performance of data transfer in distributed synchronous systems 10.

## Claims

1. A metastability detector (60) for detecting metastability of a received signal in a distributed synchronous system (10), the metastability originating from clock phase misalignment resulting from sending the signal from a first transceiver device (TX) to a second transceiver device (RX) of the distributed synchronous system (10), the metastability detector (60) comprising:
- an input configured to receive a re-synchronized signal pattern (ip) from a synchronizer device (30) of the second transceiver device (RX), the re-synchronized signal pattern (ip) being obtained by re-synchronization to a signal pattern present in the received signal (ip_i) and resulting from a toggle sequence generated in the first transceiver device (TX) with a first clock phase and a 50% duty cycle,
- an interval counter (70) configured to increment when the re-synchronized signal pattern (ip) is equal to 1 and to decrement when the re-synchronized signal pattern (ip) is equal to 0 or vice versa for subsequent logic level intervals of the re-synchronized signal pattern (ip), and
- control logic (80) configured to accumulate an absolute value of the interval counter (70) at the end of each logic level interval and to provide a metastability value based on the accumulated absolute value.

2. A metastability detector (60) according to claim 1, further comprising an internal register (90) for saving the metastability value, wherein the internal register (90) is accessible to external software.

3. A metastability detector (60) according to claim 1 or 2, wherein the control logic (80) is further configured to compare the accumulated counts to a predetermined threshold to determine if a metastability event has occurred.

4. A method for calibrating a distributed synchronous system (10) comprising a first transceiver device (TX) with a first transceiver digital sub-system (TX-SUB) connected to a second transceiver device (RX) with a second transceiver digital sub-system (RX-SUB) via an external connection (CON), the method comprising:
a. generating a toggle sequence with a clock phase and a 50% duty cycle in a pattern generator (20) in the first transceiver digital sub-system (TX-SUB), and transmitting a signal (ip_i) containing the toggle sequence to the second transceiver device (RX),
b. receiving the signal (ip_i) in the second transceiver device (RX), and synchronizing to a signal pattern present in the received signal (ip_i) and resulting from the toggle sequence by means of a synchronizer device (30) in the second transceiver digital sub-system (RX-SUB), thereby obtaining a re-synchronized signal pattern (ip),
c. incrementing an interval counter (70) when the re-synchronized signal pattern (ip) is equal to 1 and decrementing the interval counter (70) when the re-synchronized signal pattern (ip) is equal 0 or vice versa for subsequent logic level intervals of the re-synchronized signal (ip),
d. accumulating an absolute value of the interval counter (70) at the end of each logic level interval and providing a metastability value based on the accumulated absolute value,
e. optionally, repeating steps a to d at least once for a further toggle sequence with a different clock phase and with a 50% duty cycle, thereby obtaining at least one further metastability value,
f. evaluating whether the obtained metastability value or values reflect a minimal or zero metastability,
g. determine a reference clock phase correlated with the respective metastability value reflecting the minimal or zero metastability, and
h. adjust the clock phase of a signal for data transfer from the first transceiver device (TX) to the second transceiver device (RX) or vice versa according to the reference clock phase.

5. A method according to claim 4, wherein the evaluation step comprises comparing the obtained metastability value or values with a predetermined value.

6. A method according to claims 4 or 5, wherein steps a to d are repeated for
- subsequent toggle sequences of which the clock phase is adjusted in discrete steps over a range of clock phases.

7. A method according to any of claims 4 to 6, further comprising periodically re-run steps a to h in between data transfer operations.

8. A distributed synchronous system (10) comprising a first transceiver device (TX) with a first transceiver digital sub-system (TX-SUB) connected to a second transceiver device (RX) with a second transceiver digital sub-system (RX-SUB) via an external connection (CON), wherein:
- the first transceiver digital sub-system (TX-SUB) comprises a pattern generator (20) for generating a toggle sequence with a clock phase and a 50% duty cycle, and configured to generate subsequent toggle sequences with different clock phases,
- the second transceiver digital sub-system (RX-SUB) comprises:
- a synchronizer device (30) configured to receive a signal pattern present in a received signal (ip_i) and resulting from a toggle sequence generated in the first transceiver device (TX), and to produce a re-synchronized signal pattern (ip) by re-synchronization to the received signal pattern, and
- a metastability detector device (50) to provide a metastability value of the re-synchronized signal pattern (ip) indicative of the degree of metastability of the re-synchronized signal pattern (ip),
wherein the metastability detector device (50) comprises at least one metastability detector (60) according to any of claims 1 to 3, and/or
wherein the distributed synchronous system (10) is configured to perform, before use or in between data transfer operations, a calibration method according to any of claims 4 to 7 for obtaining synchronized data transfer between the first transceiver device (TX) and the second transceiver device (RX).

9. A system (10) according to claim 8, wherein the metastability detector device (50) further comprises at least one XOR based metastability detector (110) and/or at least one pattern based metastability detector (100).

10. A system (10) according claim 8 or 9, wherein the synchronizer device (30) comprises at least two Flip-Flop synchronizers (40).

11. A system (10) according to any of claims 8 to 10, wherein the system (10) is configured to periodically re-run the calibration sequence in between data transfer operations.

12. A system (10) according to any of claims 8 to 11, wherein the first transceiver device (TX) comprises a field-programmable gate array with a phase-locked loop for clock phase adjustment.

13. A system (10) according to any of claims 8 to 12, wherein the second transceiver device (RX) comprises an integrated circuit configured to provide a reference clock phase to the first transceiver device.

14. A system (10) according to any of claims 8 to 13, wherein the external connection (CON) comprises a transmitter core, transmitter pads, wires, receiver pads and a receiver core.

15. A method for enabling reliable high-speed data transfer in a distributed synchronous system (10) comprising a first transceiver device (TX) with a first transceiver digital sub-system (TX-SUB) connected to a second transceiver device (RX) with a second transceiver digital sub-system (RX-SUB) via an external connection (CON), the method comprising:
- implementing, at the second transceiver digital sub-system (RX-SUB), a metastability detector device (50) configured to detect metastability events resulting from clock phase misalignment, the metastability detector device (50) comprising at least one metastability detector (60) according to any of claims 1 to 3,
- providing, at the first transceiver device (TX), a pattern generator (20) for generating a toggle sequence with a particular clock phase and a 50% duty cycle, and configured to generate subsequent toggle sequences with different clock phases, and/or
- performing, before use and/or in between data transfer operations, a calibration method according to any of claims 4 to 7,
- selecting a clock phase resulting in a minimal or zero metastability for data transfer and
- transferring data from the first transceiver device (TX) to the second transceiver device (RX) using the selected clock phase.
